(19) Europäisches Patentamt
European Patent Office
Office européen des brevets

(11) Publication number: **0 487 794 A1**

# (12) EUROPEAN PATENT APPLICATION

(21) Application number: **90312862.7**

(22) Date of filing: **27.11.90**

(51) Int. Cl.$^5$: **G03F 7/38**, G03F 7/16, G03F 7/004, G03F 7/022

(43) Date of publication of application: **03.06.92 Bulletin 92/23**

(84) Designated Contracting States: **DE FR GB**

(71) Applicant: **SONY CORPORATION**
**7-35 Kitashinagawa 6-Chome Shinagawa-ku**
**Tokyo 141(JP)**

(72) Inventor: **Kasuga, Takashi, c/o Patents Division**
**Sony Corporation, 6-7-35 Kitashinagawa**
**Shinagawa-ku, Tokyo 141(JP)**
Inventor: **Ikeda, Rikio, c/o Patents Division**
**Sony Corporation, 6-7-35 Kitashinagawa**
**Shinagawa-ku, Tokyo 141(JP)**

(74) Representative: **Thomas, Christopher Hugo et al**
**D Young & Co 10 Staple Inn**
**London WC1V 7RD(GB)**

## (54) Process for preparing resist patterns.

(57) A process for preparing a resist pattern for lithography from a chemically amplified resist (21) composed of a photoactive acid generator includes a step of controlling a photoactive acid catalyzed reaction, induced by the acid generator, adjacent to an area of the surface which is subjected to excess irradiation. The reaction control may be performed by trapping excess acid generated adjacent to areas of the resist surface, by forming a temperature gradient in the resist to restrict the photoactive reaction in selected areas, or by charging the resist (21) in its thickness direction to move positive charge from the generated acid for establishing homogeneous charge distribution in the resist (21).

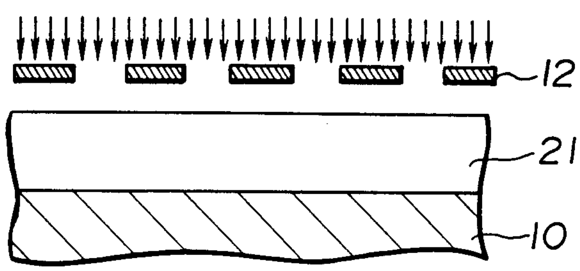


**FIG.4A**

EP 0 487 794 A1

This invention relates to processes for preparing resist patterns for photolithography techniques, and to resist patterns so prepared.

Recently, photoresists having high resolution and high sensitivity to be utilized for photolithographic techniques in the semiconductor manufacturing field have been studied. In particular, chemically amplified resists which are known to have relatively high resolution have been studied. Chemically amplified resists are based on casting or depolymerization induced by protons generated when an onium salt acid generator is irradiated with light.

Ordinary chemically amplified resist is composed of a base polymer based on resin such as cresol or hydroxystyrene, and a cross-linking agent or an acid generator as additional agents, selected from melamine derivatives (for example, methylol compounds) or polyhalide compounds.

As is known, chemically amplified resist is utilized as follows.

The chemically amplified resist is applied on a surface of a semiconductor substrate and pre-baked. The resist coated substrate is covered by a mask having patterns of uncovered portions, and is then exposed using irradiating means such as an eximer laser. Thus, exposed portions are obtained corresponding to patterns formed on the mask. After exposure, the resist coated substrate is post exposure baked (PEB), and alkaline developed in an aqueous solution. Thus, desired patterns are obtained on the substrate. From a functional view point, the resists are grouped as negative and positive types. A negative resist is composed of alkaline soluble resin, cross-linking agent and photoactive acid generator. In the exposed portion of this negative resist, protons ($H^+$), generated by a photoactive acid generator upon exposure induce an acid catalyzed reaction to promote cross-linking of the base polymer by the cross-linking agent during thermal treatment after exposure. Exposed portions are made insoluble by this cross-linking reaction in an alkaline solution, so obtaining negative patterns on the substrate.

A positive resist is composed of alkaline soluble resin, dissolution inhibitor (agent or group), and photoactive acid generator. In the exposed portion of this positive resist, protons generated by the photoactive acid generator upon exposure to light induces an acid catalyzed reaction to decompose the dissolution inhibitor during thermal treatment after exposure. Then exposed portions are dissolved in an alkaline solution upon development, to obtain a positive pattern on the substrate.

In negative and positive chemically amplified resists, protons promote sequential reaction without being consumed. Therefore, the required amount of photoactive acid generator can be reduced, and light penetration of the resists can be increased. This is very effective, especially for photolithography using eximer lasers, since the degree of light absorption influences the sensitivity of the resist.

"Semiconductor World" 1988, vol.9, pages 44 to 46 discloses a positive resit having a composition of poly(p-trimethylsiloxystyrene) as a base polymer and an acid generator with known positive resist such as o-naphtoquinonediazide (NQD)/ novolac resin. When a resin having the aforementioned composition is used for coating a substrate and is subjected to irradiation, acid generated by the photoactive acid generator induces a catalyzed reaction removing a silyl group from the polymer to obtain alkaline soluble poly (p-hydroxystyrene) as follows:

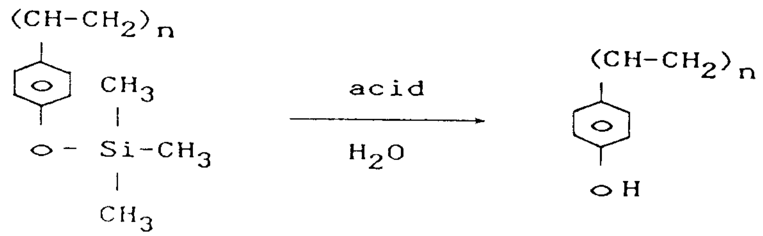


The compound obtained dissolves in an alkaline solution upon development, so a positive pattern is formed.

Alternatively, other types of negative chemically amplified resists, exposed by electron beam irradiation, have been proposed.

However, in spite of high penetration of the resist upon receiving transmitted light, the chemically amplified resists previously mentioned still have some problems as to pattern configuration. For example, remaining resin which surrounds the removed portion has a certain level of light absorption, especially adjacent to the surface area because of a higher sensitivity to irradiation compared with the deeper area. The portions surrounding the exposed portions at the surface area thus have a tendency to remain. Therefore, the negative pattern forms an inverted taper configuration and cannot define rectangular corners. On the other hand, in the positive resist, for the same reasons as for the negative resist, the portion surrounding the exposed portion at the surface area has a tendency to dissolve, so the positive pattern

assumes a tapered configuration. Therefore resolution of these resist patterns is compromised.

As shown in Figure 1, at an exposed portion, positive charges and negative charges tend to collect adjacent to the surface area of the resist. Therefore, when developing this charged resist, in the case of the positive type, a tapered configuration is formed by dissolution as shown in Figure 2, and on the other hand, in the case of the negative type, an inverted tapered configuration is formed by cross-linking of the polymer as shown in Figure 3. The resolution of the resist patterns is thus decreased.

According to the present invention there is provided a process for preparing a resist pattern for photolithography, the process comprising the steps of:

applying a chemically amplified resist including a photoactive acid generator on a substrate to form a wafer;

covering a surface of said resist with a mask having a desired pattern exposed therethrough;

exposing surface portions through said mask to light irradiation, then removing said mask from said surface;

controlling a photoactive acid catalyzing reaction induced by said acid generator at areas of said surface which are subjected to high levels of irradiation;

baking said exposed wafer; and

developing said wafer in an alkaline solution.

According to the present invention there is also provided a process for preparing a resist pattern for photolithography, the process comprising the steps of: applying a chemically amplified resist including a photoactive acid generator on a substrate to form a wafer;

covering a surface of said resist with a mask having a desired pattern exposed therethrough;

exposing surface portions through said mask to light irradiation; applying an acid trapping agent to said resist surface to trap excess acid generated by said acid generator adjacent to areas of said surface which are subjected to excess irradiation;

baking said exposed wafer; and

developing said wafer in an alkaline solution.

According to the present invention there is also provided a process for preparing a resist pattern for photolithography, the process comprising the steps of:

applying a chemically amplified resist including a photoactive acid generator on a substrate to form a wafer;

covering a surface of said resist with a mask having a desired pattern exposed therethrough;

exposing surface portions through said mask to light irradiation; removing said mask from said resist surface;

post exposure baking associated with cooling said resist surface for providing a temperature gradient in the direction of the resist thickness to restrict excess photoactive acid catalyzing reaction adjacent to the surface of said resin; and

developing said wafer in alkaline solution.

According to the present invention there is also provided a process for preparing a resist pattern for photolithography, the process comprising the steps of:

applying a chemically amplified resist including a photoactive acid generator on a substrate to form a wafer;

covering a surface of said resist with a mask having a desired pattern exposed therethrough;

exposing surface portions through said mask to light irradiation; removing said mask from said resist surface;

charging said wafer in a direction of the resist thickness to providing homogeneous charge distribution in said resist for promoting sufficient photoactive reaction throughout said resist;

post exposure baking said charged wafer; and

developing said wafer in alkaline solution.

Thus the present invention includes a process for preparing a resist pattern for photolithography, comprising the steps of applying a chemically amplified resist including a photoactive acid generator on a substrate to form a wafer, covering a surface of the resist with a mask having a desired pattern exposed therethrough, exposing surface portions through the mask to light irradiation, removing the mask from the surface, controlling a photoactive acid catalyzing reaction induced by the acid generator at areas of the surface which are subjected to high levels of irradiation, baking the exposed wafer, and developing the wafer in an alkaline solution.

The reaction control may be accomplished by applying an acid trapping agent to the wafer to remove excess acid generated by the photoactive reaction from adjacent to the resist surface.

The reaction control may alternatively be accomplished by forming a temperature gradient in the resist by cooling the resist surface upon baking to promote the photoactive reaction to be induced homogeneously in the resist.

Alternatively, the reaction control can be accomplished by applying a charge to the wafer in the direction of the thickness of the resist to induce homogeneous photoactive reaction by moving a positive

charge due to acid generated by the acid generator from adjacent to the surface to adjacent to the substrate in the resist to provide homogeneous charge distribution therein.

The invention will now be described by way of example with reference to the accompanying drawings, throughout which like parts are referred to by like references, and in which:

Figure 1 is a sectional view of a resist during exposure;

Figure 2 is a sectional view of a positive resist after development;

Figure 3 is a sectional view of a negative resist after development;

Figures 4A to 4D are sectional views showing a process for preparing a resist pattern according to a first embodiment of the present invention;

Figures 5A to 5D are section views showing a process for preparing a resist pattern according to a second embodiment of the present invention;

Figures 6A to 6D are sectional views showing a process for preparing a resist pattern according to a third embodiment of the present invention;

Figures 7 to 8 are wave patterns of high frequency voltage utilized during the process of the third embodiment.

Referring now to the drawings, particularly to Figures 4A to 4D, a negative chemically amplified resist 21 including photoactive acid generator is applied to the surface of a semiconductor substrate 10 to form a wafer. The resist 21 is prepared by addition of photoactive acid generator which generates hydrogen halide upon light irradiation (exposure) and a cross-linking agent for cresol resin. The surface of the resist 21 is covered by a photomask 12 on which a desired resist pattern is formed and is then exposed to light irradiation to form exposed portions 21A as shown in Figure 4B. As the area adjacent to the surface of the resist 21 is subjected to stronger light than the deeper area thereof, the exposed portions 21A form as an inverted taper configuration as shown in Figure 4B.

The exposed wafer is immersed in an imidazole solution acid trapping agent. The surface of the resist 21 is subjected to imidazole, and acid generated in the exposed portions 21A is trapped by the imidazole, especially at the area adjacent to the surface of the resist 21, rather than the area adjacent to the substrate 10. The amount of trapped acid decreases from the surface to the inner portion of the resist 21. As the centres of the exposed portions 21A are subjected to strong light, acid concentration in those areas becomes high, so the amount of acid is sufficient to induce a cross-linking reaction of the resin. On the other hand, as the areas adjacent to the peripheral areas 21b of the exposed portions 21A are subjected to relatively weak light, acid concentration is limited to a relatively low level, so the acid generated is trapped by the imidazole and a cross-linking reaction of the resin cannot occur. Thus, the peripheral area 21b is made soluble while the portion 21a which is strongly influenced by irradiation is made insoluble as shown in Figure 4C. After the imidazole treatment, the wafer is subjected to PEB, and alkaline development. A desired negative resist pattern having rectangular corners as shown in Figure 4D is obtained, and finally, treatment such as rinsing or hard baking is applied in order to establish the pattern formation. A desired, precise configuration of positive resist pattern is also obtained by acid trapping treatment using an acid trapping agent such as imidazole as described above. The acid generator, trapping agent, cross-linking agent, and base polymer of the resist can be modified as needed. For example, a solution of tertiary amines type having weak basicity may be preferred as the acid trapping agent. Alternatively, acid trapping can be accomplished before exposure.

Figures 5A to 5D show another embodiment of the present invention. A positive chemically amplified resist 31 is applied to the surface of a semiconductor substrate 10 as shown in Figure 5A to from a wafer. The surface of a resist 31 is covered by a photomask 12 on which a desired resist pattern is formed, and is then exposed by light irradiation to form exposed portions 31A. Similarly to the first embodiment, the exposed portions 31A form as an inverted tapering configuration as shown in Figure 5B. After exposure, the wafer is subjected to PEB treatment, while concurrently cooling the surface of the resist 31, using a baking apparatus. The apparatus has a heating means and a cooling means which is located opposite the heating means. At the surface of the cooling means where it contacts the resist surface, a plurality of nozzles are located to discharge cooled nitrogen gas from the cooling means. During baking, as the surface of the resist 31 is cooled to a greater degree than the deeper area thereof, a temperature gradient is formed, that is, the resist temperature rises from the surface to the lower area.

Thus insolubilizing reaction of the resist is promoted at the cooled surface of the resist 31, while the lower surface thereof is not so insolubilized. On the other hand, as a solubilizing reaction of the resist depends on the acid catalytic reaction, solubilizing of the cooled surface area is restricted. Therefore, the insolubilized portion 31b is formed at the periphery of the exposed portions 31A leaving remaining portions 31a in the area strongly influenced by irradiation.

Then, after development, only the solubilized portion 31a is dissolved in the alkaline solution, so a

desired pattern having rectangular corners is obtained.

In the case of a negative resist, a cross-linking reaction of a resin is promoted by raising the temperature of the PEB. For this reason, exposed portions of the known negative resin have an inverted tapering configuration. However, in the present case, by cooling the resist surface using nitrogen has during the PEB, similar to the case of a positive pattern aforementioned, the cross-linking reaction of the cooled surface is more restricted than in the deeper area of the resist. Therefore, desired configurations of patterns having rectangular corners are obtained.

In the second embodiment aforementioned, the cooling means is not limited to nitrogen gas and any suitable gas may be applied as a coolant. Additionally, it is possible to combine the exposure step and the PEB step in a common apparatus.

Figures 6A to 6D shown the third embodiment of the present invention. A positive chemically amplified resist 41 is applied on a semiconductor substrate 10 to form a wafer as shown in Figure 6A. The resist 41 is composed of a cresol resin and photoactive acid generator. The surface of the resist 41 is covered by a photomask 12 similar to the aforementioned embodiments, and then exposed by irradiation to form exposed portions 41A as shown in Figure 6B. Positive charges occurring from protons generated by the acid generator and negative charges from a base are distributed in the area of the exposed portions 41A from the surface to the centre portion of the resist 41. Then, the wafer is sandwiched between a pair of electrodes 15A and 15B, and electric power is applied. The electrode 15A, applied to the resist side, is the positive electrode, and the electrode 15B applied to the substrate side is the negative electrode. Protons (positive charge) distributed in the surface area of the exposed portion 41A are moved to the negative side, and the distribution of the positive charge is averaged in the exposed portion 41A as shown in Figure 6C. Thereafter, the wafer is subjected to a PEB. During the PEB, solubilizing of the resist is promoted by protons. Thus, a desired configuration of resist patterns having rectangular corners is obtained after development. Therefore, the resolution of the resist 41 can be increased, and the focus margin thereof is increased. Proton concentration in a peripheral area at the border of the exposed portions 41A and the unexposed portions is restricted to a level less than the level of solubilization caused by the PEB. Therefore, as a result, the adjacent border area is insolubilized.

Charging as aforementioned can be applied to preparation of resist patterns using a negative resist. Desired patterns having rectangular corners are also obtained similarly to the processing of positive resists.

Alternatively, the charging may be applied during the PEB. In this application, the negative electrode 15B can be associated with a member attached to the baking apparatus. As a means of moving the protons, high frequency voltage, as shown in Figures 7 and 8, or bias may be applied. When utilizing high frequency voltage having a waveform such as indicated in Figure 7, since the positive pulse width is greater than the negative pulse width, positive charges, are moved to the side adjacent to the substrate in the resist, and the positive charge distribution can be averaged in the exposed portion. Similar results can be obtained when utilizing high frequency voltage having a waveform such as indicated in Figure 8. Additionally, in the case of utilizing such high frequency voltages, a baking step by a baking apparatus is not necessary for pattern preparation, because dielectric loss occurs in the resist by application of the high frequency voltage.

Alternatively, the charging can be accomplished before and during the PEB. The application of high frequency voltage can be accomplished after controlling proton distribution by a DC voltage, then dispersion of protons in a direction transverse to that of voltage application can be restricted.

Thus, excess photoreaction can be sufficiently restricted in the resist, adjacent to the surface which is subjected to irradiation, by trapping excess acid generated there or cooling the surface upon PEB. Sufficient photoreaction can occur in the resist at a side remote from the surface because the charge distribution raised by the photoreaction is averaged to form a homogeneous charge distribution.

Therefore, resolution of the resist pattern can be substantially increased because a precise configuration corresponding the design formed on the photomask can be obtained.

**Claims**

1. A process for preparing a resist pattern for photolithography, the process comprising the steps of:
   applying a chemically amplified resist (21) including a photoactive acid generator on a substrate (10) to form a wafer;
   covering a surface of said resist (21) with a mask (12) having a desired pattern exposed therethrough;
   exposing surface portions (21A) through said mask (12) to light irradiation, then removing said mask (12) from said surface;
   controlling a photoactive acid catalyzing reaction induced by said acid generator at areas of said surface which are subjected to high levels of irradiation;

baking said exposed wafer; and
developing said wafer in an alkaline solution.

**2.** A process according to claim 1 wherein said controlling step comprises applying an acid trapping agent to said wafer to remove excess acid generated by said photoactive reaction from adjacent to said resist surface.

**3.** A process according to claim 1 wherein said controlling step comprises forming a temperature gradient in said resist (21) by cooling the resist surface upon said baking to promote said photoactive reaction to be induced homogeneously in said resist (21).

**4.** A process according to claim 2 wherein said acid trapping agent is applied to said wafer before said exposing.

**5.** A process according to claim 2 wherein said acid trapping agent is applied to said wafer after said exposing.

**6.** A process according to claim 2 wherein said acid trapping agent is a tertiary amine solution having weak basicity.

**7.** A process according to claim 3 wherein said cooling of said resist surface is accomplished by discharging nitrogen gas onto said surface.

**8.** A process according to claim 3 wherein said exposing is combined with said baking.

**9.** A process according to claim 1 wherein said controlling step comprises applying an electric potential across said wafer in the direction of the thickness of said resist (41) to induce homogeneous photoactive reaction by moving positive charges generated by said acid generator from adjacent to the surface to adjacent to the substrate (10) in said resist (41) to provide homogeneous charge distribution therein.

**10.** A process according to claim 9 wherein said potential is applied before said baking.

**11.** A process according to claim 9 wherein said potential is applied during said baking.

**12.** A process according to claim 9 wherein said potential is applied by applying electric voltage via a pair of electrode plates (15A, 15B) located on respective sides of said wafer, the electrode (15A) on the side of said resist (41) being positive and the electrode (15B) on the side of said substrate (10) being negative.

**13.** A process according to claim 12 wherein said negative electrode (15B) plate is combined with a baking apparatus for said baking.

**14.** A process according to claim 12 wherein said voltage is a high frequency voltage in which the positive pulses are wider than the negative pulses.

**15.** A process according to claim 12 wherein said voltage is biased in the positive direction.

**16.** A process according to claim 9 wherein said charging is accomplished before and during said baking.

**17.** A process according to claim 9 wherein said charging is accomplished by applying DC voltage to control proton distribution, and then applying high frequency heating thereafter.

**18.** A process for preparing a resist pattern for photolithography, the process comprising the steps of:
applying a chemically amplified resist (21) including a photoactive acid generator on a substrate (10) to form a wafer;
covering a surface of said resist (21) with a mask (12) having a desired pattern exposed therethrough;
exposing surface portions through said mask (12) to light irradiation; applying an acid trapping agent to

said resist surface to trap excess acid generated by said acid generator adjacent to areas of said surface which are subjected to excess irradiation;
baking said exposed wafer; and
developing said wafer in an alkaline solution.

**19.** A process for preparing a resist pattern for photolithography, the process comprising the steps of:
applying a chemically amplified resist (21) including a photoactive acid generator on a substrate (10) to form a wafer;
covering a surface of said resist (21) with a mask (12) having a desired pattern exposed therethrough;
exposing surface portions through said mask (12) to light irradiation; removing said mask (12) from said resist surface;
post exposure baking associated with cooling said resist surface for providing a temperature gradient in the direction of the resist thickness to restrict excess photoactive acid catalyzing reaction adjacent to the surface of said resin; and
developing said wafer in alkaline solution.

**20.** A process for preparing a resist pattern for photolithography, the process comprising the steps of:
applying a chemically amplified resist (41) including a photoactive acid generator on a substrate (10) to form a wafer;
covering a surface of said resist (41) with a mask (12) having a desired pattern exposed therethrough;
exposing surface portions through said mask (12) to light irradiation;
removing said mask (12) from said resist surface;
charging said wafer in a direction of the resist thickness to providing homogeneous charge distribution in said resist (41) for promoting sufficient photoactive reaction throughout said resist (41);
post exposure baking said charged wafer; and
developing said wafer in alkaline solution.

**21.** A resist pattern of precise configuration having rectangular corners which corresponds to a desired pattern previously prepared by a process comprising the steps of claim 1.

**22.** A resist pattern of precise configuration having rectangular corners which corresponds to a desired pattern previously prepared by a process comprising the steps of claim 18.

**23.** A resist pattern of precise configuration having rectangular corners which corresponds to a desired pattern previously prepared by a process comprising the steps of claim 10.

**24.** A resist pattern of precise configuration having rectangular corners which corresponds to a desired pattern previously prepared by a process comprising the steps of claim 20.

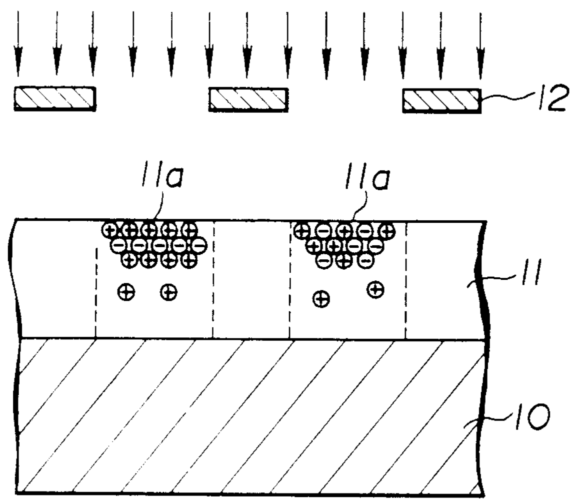


FIG.1

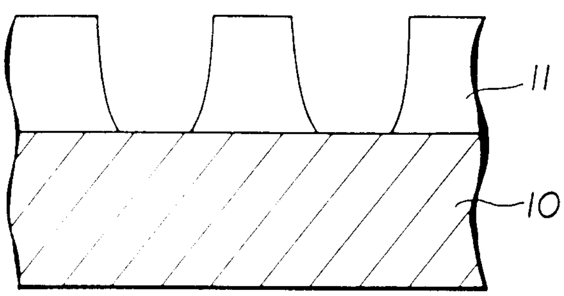


FIG.2

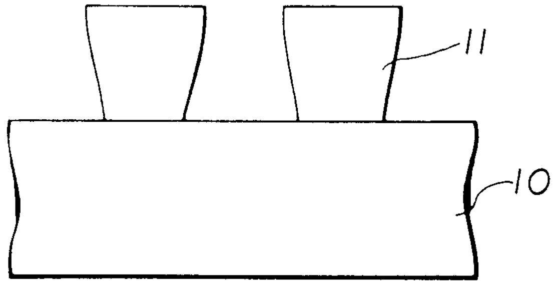


FIG.3

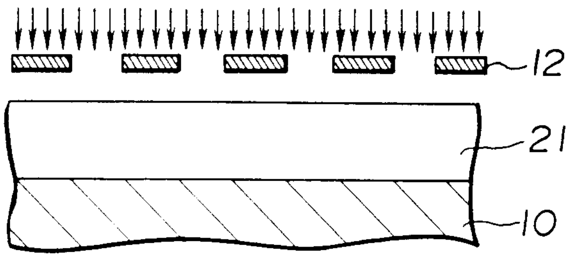


FIG.4A

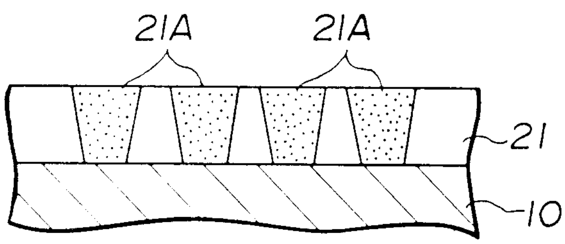


FIG.4B

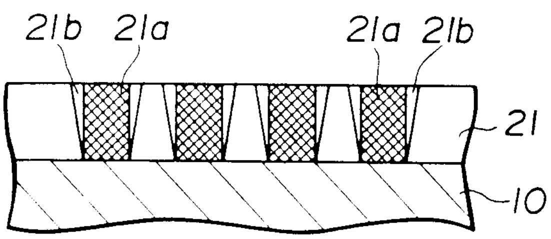


FIG.4C

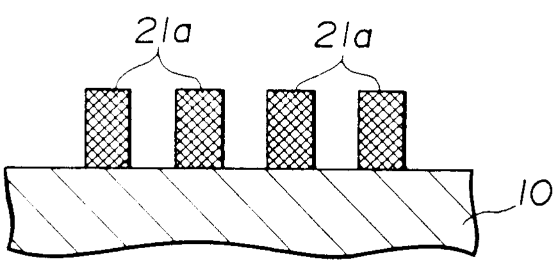


FIG.4D

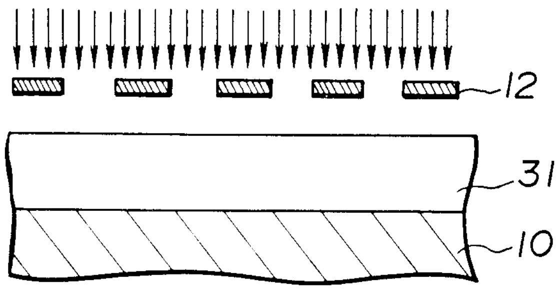


FIG.5A

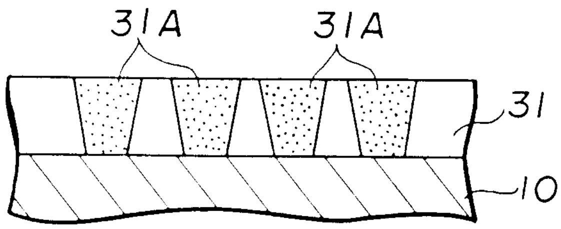


FIG.5B

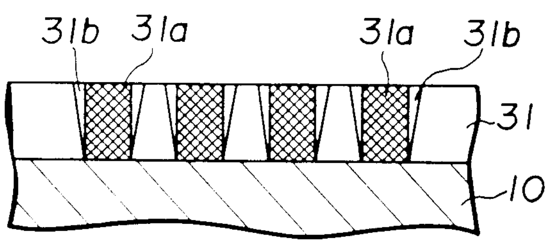


FIG.5C

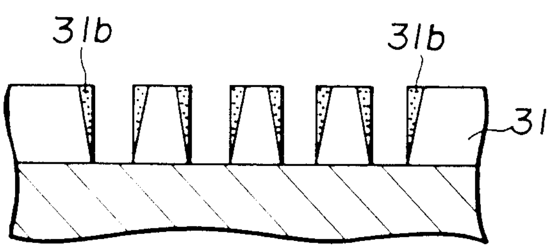


FIG.5D

FIG.6A

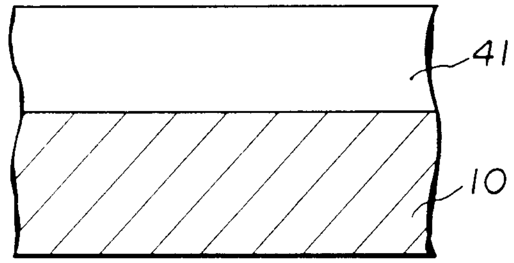


FIG.6B

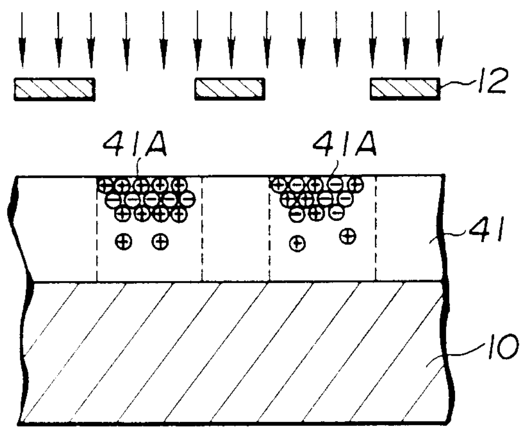


FIG.6C

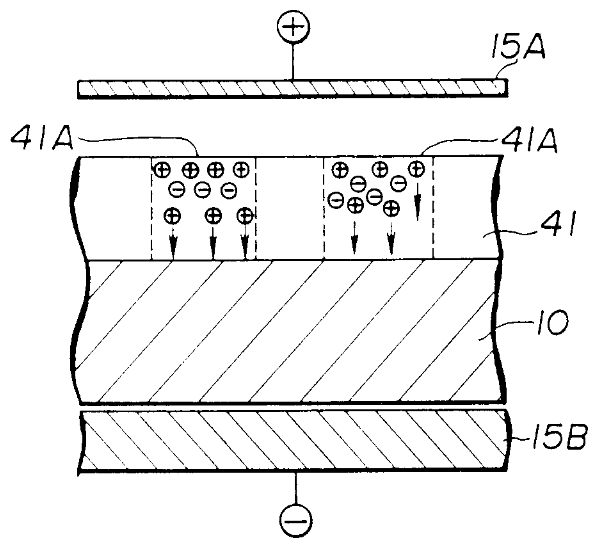


FIG.6D

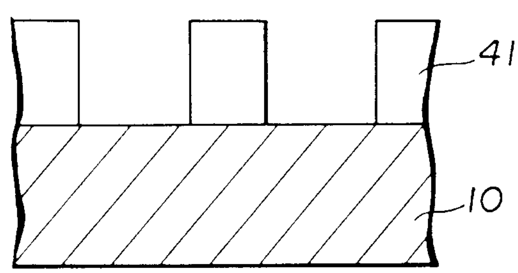

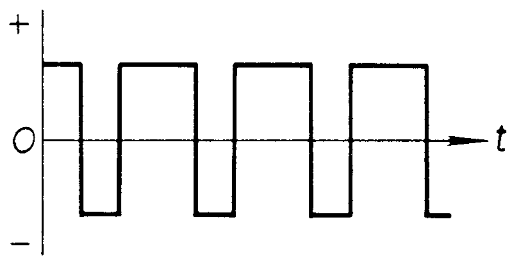


FIG. 7

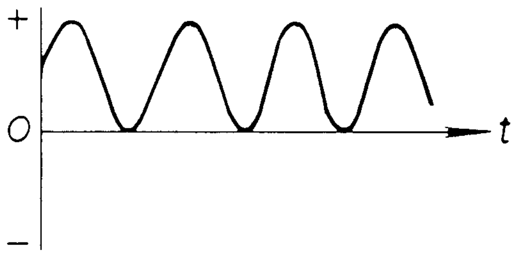


FIG. 8

European Patent Office

# EUROPEAN SEARCH REPORT

Application Number

EP 90 31 2862

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | US-A-4775609 (MC FARLAND M.J.)<br>* column 3, line 56 - column 4, line 15; claim 1 *<br>--- | 1, 5, 6, 18, 21, 22 | G03F7/38<br>G03F7/16<br>G03F7/004<br>G03F7/022 |
| Y | GB-A-2171530 (IMTEC PRODUCTS INC)<br>* the whole document *<br>--- | 1, 2, 5, 18, 21 | |
| Y | IBM TECHNICAL DISCLOSURE BULLETIN.<br>vol. 21, no. 6, November 1978, NEW YORK US<br>pages 2306 - 2308; HAVAS J. & PAAL G.:<br>"CONTROL OF DEVELOPED IMAGE IN AZ-TYPE PHOTO AND ELECTRON RESIST"<br>* the whole document *<br>--- | 1, 2, 4-6, 18, 21 | |
| Y | RESEARCH DISCLOSURE.<br>no. 259, November 1985, HAVANT GB<br>page 574 ANONYMOUS:<br>"ENHANCED PHOTORESIST DEVELOPING AND STRIPPING"<br>* the whole document *<br>--- | 1, 2, 4-6, 18, 21 | |
| A | IBM TECHNICAL DISCLOSURE BULLETIN.<br>vol. 15, no. 2, July 1972, NEW YORK US<br>page 426 TAFT L.G.:<br>"ELECTROSTATICALLY REMOVING COATING SPRAY WHILE SPIN COATING"<br>* the whole document *<br>--- | 9-17 | **TECHNICAL FIELDS SEARCHED (Int. Cl.5 )**<br><br>G03F |
| A | PATENT ABSTRACTS OF JAPAN<br>vol. 12, no. 298 (P-744)(3145) 15 August 1988,<br>& JP-A-63 71842 (HITACHI LTD) 01 April 1988,<br>* the whole document *<br>----- | 9-17 | |

The present search report has been drawn up for all claims

| Place of search | Date of completion of the search | Examiner |
|---|---|---|
| THE HAGUE | 29 JULY 1991 | LUDI M.M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)